(19) Europäisches Patentamt / European Patent Office / Office européen des brevets

(11) **EP 1 852 706 B1**

(12) **EUROPEAN PATENT SPECIFICATION**

(45) Date of publication and mention
of the grant of the patent:
**28.10.2009 Bulletin 2009/44**

(51) Int Cl.:
***G01R 31/3185*** *(2006.01)*

(21) Application number: **06009228.5**

(22) Date of filing: **04.05.2006**

(54) **Adaptive scan compression architecture**

Adaptive Scan-compression Architektur

Architecture adaptive de compression de balayage

(84) Designated Contracting States:
**DE FR GB IT**

(43) Date of publication of application:
**07.11.2007 Bulletin 2007/45**

(73) Proprietor: **STMicroelectronics S.r.l.**
**20041 Agrate Brianza (Milano) (IT)**

(72) Inventor: **Casarsa, Marco**
**20069 Vaprio d'Adda (Milano) (IT)**

(74) Representative: **Botti, Mario**
**Botti & Ferrari S.r.l.,**
**Via Locatelli, 5**
**20124 Milano (IT)**

(56) References cited:
**EP-A- 1 536 244          WO-A-01/38889**
**US-A1- 2003 131 298**

**Description**

<u>Field of application</u>

The present invention relates in its more general aspect to a Design For Testability (DFT) structure inserted into a SoC (System on Chip) including an embedded Flash memory portion for testability requirements.

More specifically, the invention relates to an improved scan compression architecture for a Design For Testability compiler used in System-on-Chip software design tools. The invention further relates to a method of designing an improved scan compression architecture through a Design For Testability (DFT) compiler used in System-on-Chip.

The invention particularly, but not exclusively, relates to a modification of the flow of a standard DFT Compiler tool available on a software tool known as Synopsys to implement an improved scan compression architecture on a SoC including an Embedded Flash memory, developed into automotive segment, and the following description is made with reference to this field of application for convenience of explanation only.

<u>Prior art</u>

EP-A-1 536 244 (TEXAS INSTRUMENTS INC, 01.06.2005) discloses a scan compression architecture comprising a scan compressor configuration that is selectively enabled by an external control signal.

As it is well known in this specific technical field, the testing costs for complex System-on-Chip (SoC) Integrated Circuits (ICs) is growing fast, especially in the case of devices including non-volatile memory portions.

According to the prior art, in order to reduce the test cost of complex SoC ICs (Integrated Circuits) including an Embedded Flash memory, three different possibilities can be chosen:

    i) reduce the Embedded Flash intrinsic test time;

    ii) insert a partial/full BIST (Built-In Self Test) solution;

    iii) increase the test parallelism by probing a small subset of pins;

The first two solutions can have a big impact on the device area, so the third solution is mostly the preferred one.

Using a standard software tool provided by Synopsys and including an adaptive compression architecture with a limited number of pins, and consequently scan chains, it's possible to perform the EWS test but the Final Test (FT) phase is limited because of the excessive data volume, which is a main drawback especially in case of low cost test equipment.

A specific design tool available in said software tool and known as Design For Testability (DFT) compiler allows the implementation of different architectures to improve the flexibility of the DFT structures inserted in the SoC for specific test requirements.

Two architectural solutions provided by the DFT compiler, namely a multi-mode architecture and an adaptive scan architecture, will be reported here below.

A first available solution is known as multi-mode architecture that is an option allowing implementation of multiple scan chains configurations (or modes). It is common in this environment to have two configurations: a standard scan chain mode and a Burn-In scan chain mode.

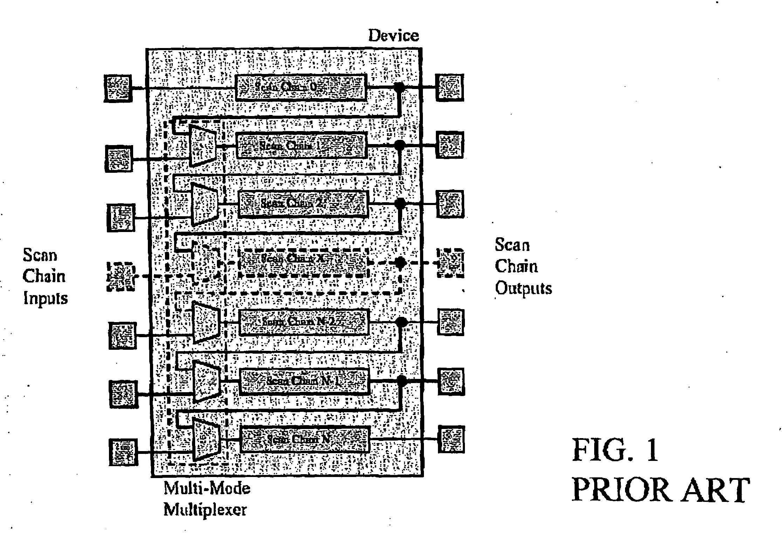

In the standard scan chain mode the number of internal scan chains depend on the maximum number of available I/O PADs at top level, and on. Test Equipment constraints. These features are schematically reported in the enclosed Figure 1 showing a Improved architecture with N scan chains.

In the Burn-In scan chain mode all internal scan chains are serially connected in a single long scan chain by means of the improved mutiplexer, allowing a higher parallelism in the testing step since more devices can be tested in parallel . So, Figure 1 shows also the alternative solution wherein a improved multiplexer shown by the dotted line connects all the chains in a single long chain.

An adaptive scan architecture is optionally available for allowing insertion of a decompression multiplexer logic block between fewer external scan chain inputs and the internal scan chain inputs, along with a compression XOR logic based block between the internal scan, chain outputs and fewer external scan chain outputs.

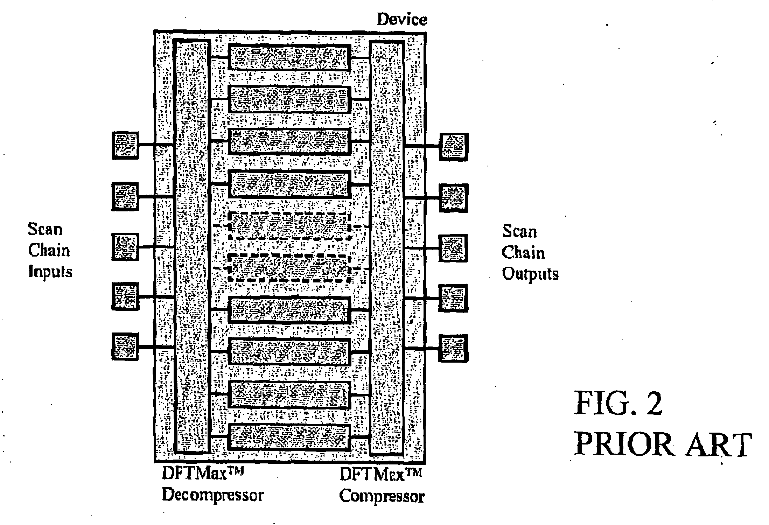

This further available solution is schematically shown in Figure 2 wherein the main hardware portions are shown.

The decompression multiplexer connects several, internal scan chain inputs to a single external scan chain input, so allowing a higher degree of parallelism in testing step, quantified in the compression factor parameter: compression factor = (number of internal scan chains)/(1.2 * number of external scan chains).

These known solutions still present some limitations mainly when there is the need to perform testing steps requiring different, degrees of parallelism. More specifically, the increasing complexity of the current System-on-Chip (SoC) Integrated Circuits (ICs), especially but not only those including embedded Flash memories, along with the increasingly stringent quality mandates, gives rise to a consequent increase of the overall test cost which does not conciliate with the current trend to reduce as much as possible the device delivery time.

The problem is particularly relevant when the inserted DFT structure needs to be used both in testing steps where a high degree of parallelism is required (e.g. EWS), and in testing steps where a low degree of parallelism is required (e.g. FT).

The technical problem underlying the present invention is that of providing a DFT architecture solution that meets the above stated requirements and having structural and functional characteristics which allow to reduce the testing cost, in terms of test time and test data volume for complex System-on-Chip ICs, in, this way overcoming the limits which still affect the DFT structures realised according to the prior art.

## Summary of the invention

The solution idea underlying the present invention is that of increasing the Test Parallelism at the EWS (Electrical Wafer Sort) steps by probing only a limited subset of pins. This is obtained providing at TOP level a dual mode scan hardware architecture that uses two different adaptive scan compressor configurations; a first configuration, named $MIN_{CONF}$, that is used for example during EWS (Electrical Wafer Sort) test in order to increase the degree of parallelism of testing; a second configuration, named $MAX_{CONF}$, that is used for example during FT (Final Test) to reduce the testing time.

On the basis of such solution idea the technical problem is solved by an improved architecture as previously indicated and defined by the characterizing part of claim 1.

Another embodiment of the invention related to a method of designing an improved scan compression architecture through a Design For Testability (DFT) compiler according to claim 11.

The characteristics and advantages of the proposed improved scan hardware architectural solution according to the invention will be apparent from the following description of embodiments thereof given by way of indicative and non limiting example with reference to the annexed drawings.

## Brief description of the drawings

In such drawings:

Figure 1 schematically shows a prior art solution of a Improved scan compression architecture with N scan chains;

Figure 2 schematically shows another prior art solution concerning an adaptive scan architecture;

Figure 3 schematically shows an improved scan compression architecture according to the present invention and including a TOP level modified to include share output multiplexer logic;

Figure 4 schematically shows a CORE logic incorporated into the improved architecture of the invention;

Figures 5 schematically shows the TOP level structure of Figure 3 including a $MAX_{CONF}$ architecture according to the invention;

Figures 6 schematically shows the TOP level structure of Figure 3 including both the $MAX_{CONF}$ of Figure 5 and a $MIN_{CONF}$ architectures according to the invention;

Figure 7 is another schematic view of the improved scan compression architecture according to the present invention.

## Detailed description

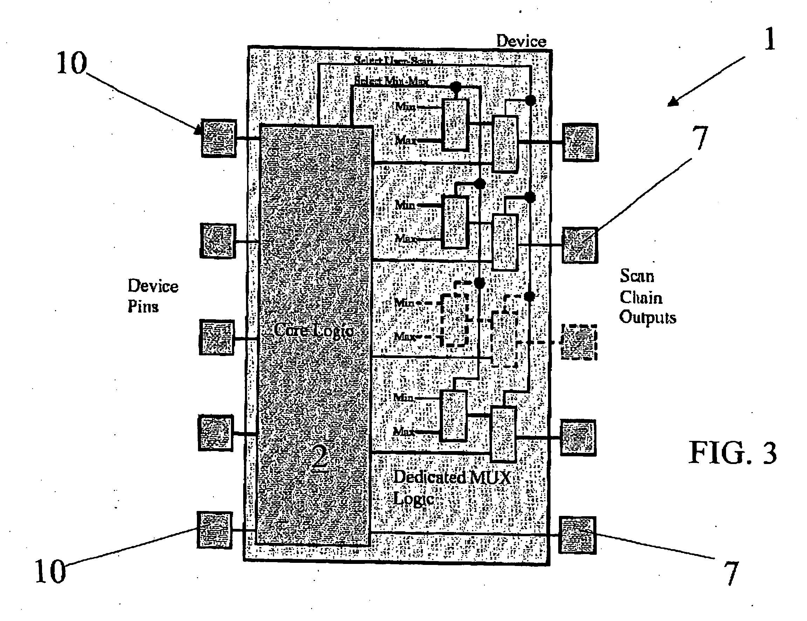

With reference to such figures, and in particular to the example from Figures 3 to 7 , an improved scan compression architecture according to the present invention is globally and schematically shown at 1 in the passages from its initial set up to its final layout through the design activity performed by a DFT compiler.

This improved scan compression, architecture 1 has been specifically designed for a DFT compiler incorporated into a standard software tool commercially known, as Synopsys that is available for designers of System-on-Chip Integrated Circuits for providing assistance in their a design activity.

Advantageously, according to the invention, this improved scan compression architecture includes a Core Logic 2 with at least a couple of adaptive scan compressor configurations, a $MIN_{CONF}$ 3 configuration and a $MAX_{CONF}$ 4 configuration, as will be clearer understood by the following description.

The basic idea of the invention is that of inserting into the SoC IC two different compressors: one $MIN_{CONF}$ has the target to allow the application of scan patterns in the EWS steps, so with a very limited number of scan chains 6 to allows high parallelism, while the other $MAX_{CONF}$ has the target to reduce as much as possible the test time and test data volume in the FT steps in which all the PADs are connected to the test equipment.

Using the improved architecture of the invention it is possible increasing a lot the parallelism during the EWS steps in order to reduce the cost of the Embedded Test Flash that generally takes lots of seconds just probing a very limited number of pins (typically sixteen pins) but at the same time having the possibility to apply the digital patterns to test the digital logic using the classical scan approach.

In a typical test flow provided by the prior art solution there is just a compressor architecture (equivalent to the $MAX_{CONF}$ compressor of the present invention) which obliges the designers to apply a dedicated EWS step probing all the pins in order to check the digital logic before packaging.

The proposed solution allows to remove this steps because, taking advantage of the $MIN_{CONF}$ compressor architecture, a lots of the test data volume can be reduced, so it's possible to reach a good coverage among different faults family (mainly stuck-at and transition) also in the EWS steps with the actual limitation of the Low cost tester (mainly the vectors mexnory).

Moreover, having the possibility to configure the compression architecture, the $MAX_{CONF}$ compressor may be enabled in the FT steps.

This solution allows reducing a lot the test time at the FT steps (all pins contacted, so very low parallelism) because the embedded Flash memory portion is no more tested in a deep mode like in the EWS steps and the big amount of the test time is related just to the digital logic.

At the same time, having a high compression ratio architecture, a specific patterns able to cover new family of faults may be applied with very high coverage (bridging transition and path delay faults) other than the classical stuck-at fault without requiring a very big Test Equipment vector memory.

So, the two compressors architectures allow satisfying the reduction of the test time in both the steps EWS and FT and at the same time to increase the overall quality of the test.

This optimization would not be possible using only one compression architecture, as in the prior art solutions.

It worth while to note that the overhead in term of area of this Multi Scan Architecture is really negligible since the largest part of the circuit area is occupied by the $MAX_{CONF}$ compressor 4 architecture that is already implemented in the prior art solutions.

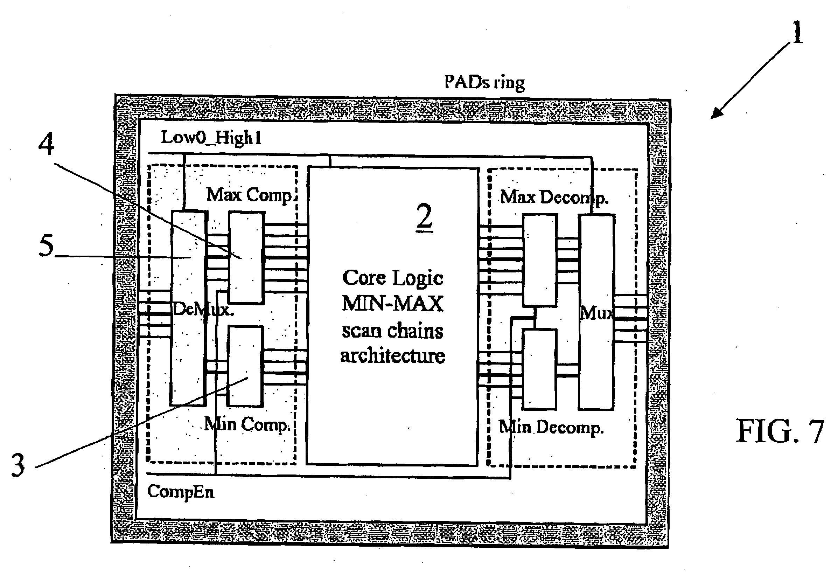

In Figure 7 it has been reported schematic view of the final architecture according to the inventive solution and that is implemented using the DFT tool ("Adaptive Scan").

This implementation has been considered as a test case to validate the quality of the inventive solution using the cad tool currently in use.

As may be appreciated, a control signal *Low0_High1* selects the architecture that has to be enabled in the Core Logic 2. So, one or the other compressor is selectively enabled by the control signal.

This selection depends on the external pins 10 probed/contacted (EWS or FT) and configure the Mux-Demux 5 in order to map the scan chains 6, 8 on the specific scan chains input/output pins 10, 7.

An additional control signal *CompEn* selects instead the behavior of the enabled compressor logic that has been selected using the *Low0_High1* signal.

Different couples of input decompressor multiplexer and output XOR logic compressor are provided, depending on the number of external scan chains, with proper connections to input and output PADs 10, 7, and mode selectable by means of the external control signal.

Each of the two compression architectures $MIN_{CONF}$ or $MAX_{CONF}$ allows two operating modes that are: enabling the compressor or simply bypassing it.

In the first mode the compressor 3 or 4 is used to reduce the test time and data volume by using the selected compression architecture (Min/Max) while in the other mode the compressor may be bypassed to perform special debug, for instance a bitmapping capability without any loss of data.

In general, these two signals *Low0_High1* and *CompEn* can be directly connected to the PADs 10 or they can be generated internally (using for example a JTAG IEEE 1149.1 standard architecture). In this manner it is offered a possibility to enable the compressor 3 or 4 with one of the two signals.

Let's now see in mode details the operating activities of the improved scan compression architecture 1.

As we have already seen, each one of the two modes will implement an adaptive scan compression architecture which is targeted to a specific test requirement.

One mode will include five external scan chains 6, suitable for Electrical Wafer Sort (EWS) testing step, and is assigned to the $MIN_{CONF}$ compressor 3 configuration.

The second mode will include twenty-three external scan chains 8, suitable for Final Testing (FT) step and is assigned to the $MAX_{CONF}$ compressor 4 configuration.

It should be noted that a modification of the standard DFT Compiler flow is necessary for the implementation of the dual scan architecture of the present invention.

So, hereinafter we will see in more detail the modifications of the standard flow of Synopsys DFT Compiler tool that shall be performed in order to achieve the above described DFT structure.

The starting point is the Test-Ready netlist at the TOP level.

The first step passes from having grouped analogue and digital logic in the single CORE logic block 2, in order to have only this block and the I/O PADs 10 and 7 at TOP level.

In this specific case, the Test Access Mechanism (TAM) is based on a JTAG IEEE 1149.1 protocol, so dedicated internal control signals properly force the needed I/O PADs according to the selected test mode, $MAX_{CONF}$ 4 or $MIN_{CONF}$ 3.

The control signals, embedded into the CORE logic 2, need to be used at TOP level in the following steps. In order to overcome this problem, dedicated output ports have been added to the CORE logic block 2 and connected to these internal control signals.

A second optional step requires a manual modification of the TOP level of the device to insert the scan data out multiplexer, connected to the output PADs shared between $MAX_{CONF}$ and $MIN_{CONF}$ mode. This is an optional step that could be avoided considering two separate groups of output PADs 7 for the two modes. In Fig. 3 the TOP level structure resulting from this operation is reported.

A third step provides for the insertion of the reconfigurable scan chains into the CORE block 2. The correct number of internal scan chains for each one of the two modes may be selected according to the compressor factor formula for a DFT adaptive scan architecture:

$$\text{compression factor} = (\text{internal chains})/(1.2 * \text{external chains}).$$

For the $MAX_{CONF}$ 4 compressor the number of external scan chains has been set to twenty-three, and a compression factor 15X has been chosen, while for the $MIN_{CONF}$ 3 compressor the number of external scan chains has been set to five, and a compression factor of 4X has been chosen.

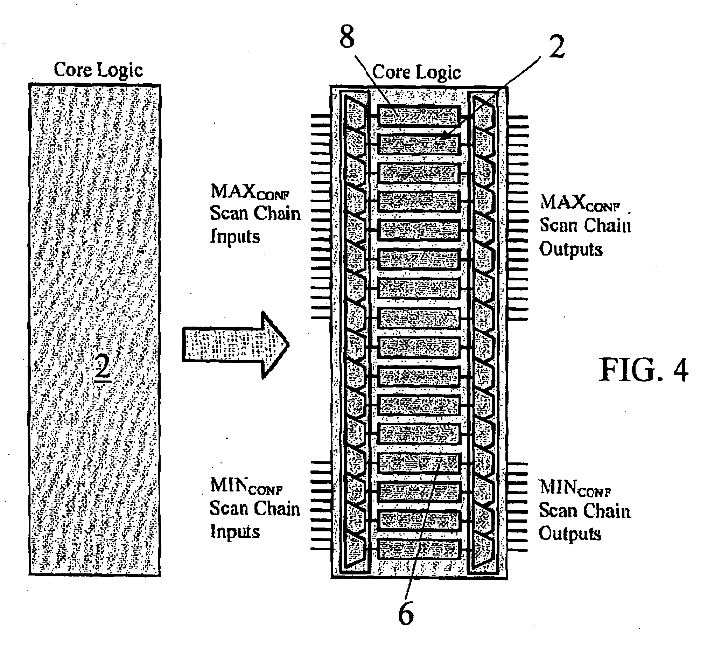

In Fig. 4 the resulting CORE block 2 is shown.

Starting from the resulting circuit of this last step, it is not possible to save the two related test models (ctldb) using the DFT Compiler in order to insert the dual scan compression architecture in later steps.

A fourth step is then a workaround allowing the test model generation for the $MIN_{CONF}$ 3 compressor architecture only, by masking the other mode $MAX_{CONF}$ 4 compressor architecture.

The previous step is then replicated to generate the $MAX_{CONF}$ ctldb, by masking the $MIN_{CONF}$ made.

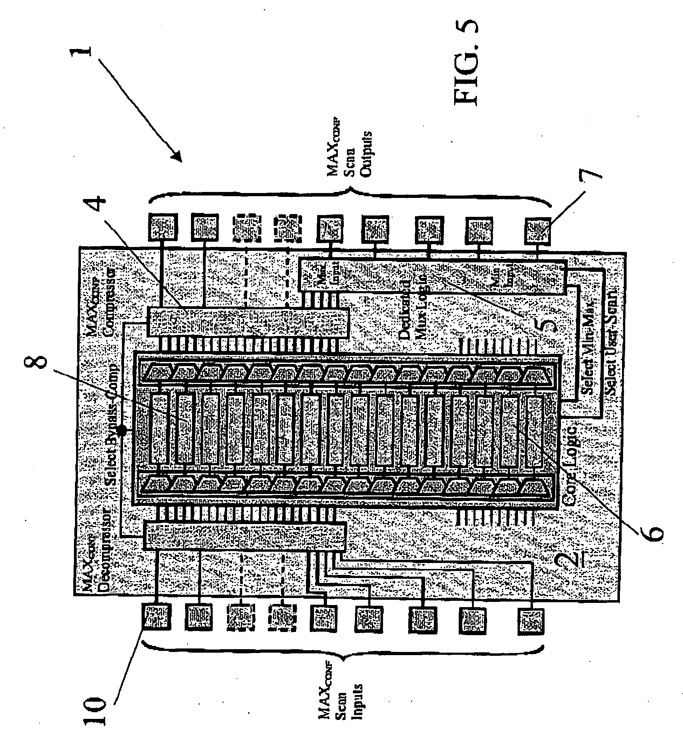

The TOP level circuit so modified to introduce the scan data out multiplexer (according to the second step) along with the ctldb which includes the $MAX_{CONF}$ configuration only, obtained in the previous step, can now be used to run the DFT Compiler to configure the DFT architecture that fits the requested compression ratio of the $MAX_{CONF}$ mode. The circuit achieved at the end of this step is shown in Fig. 5.

Using the TOP level circuit above modified, along with the ctldb related to the $MIN_{CONF}$ configuration only, it is now possible to run DFT compiler, similarly to the previous step, to configure the DFT architecture compliant to the compression ratio of $MIN_{CONF}$ mode.

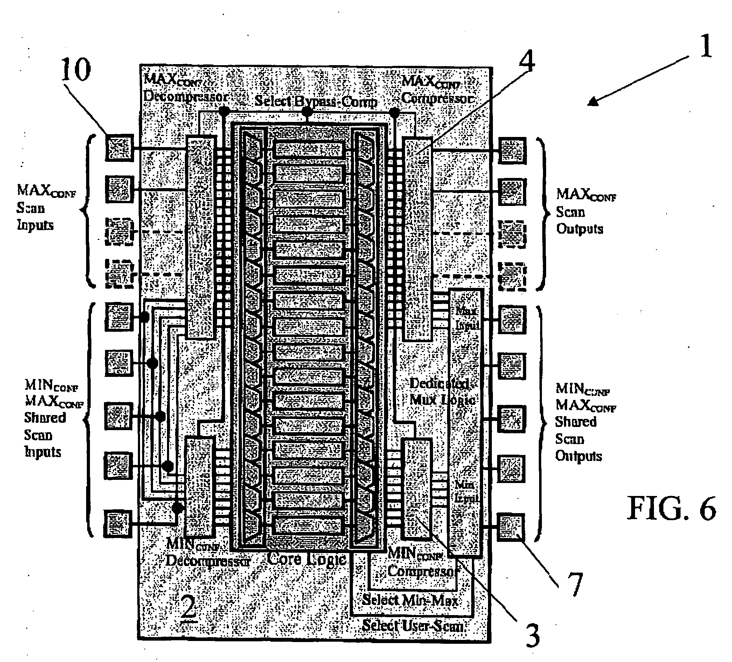

In this step, besides performing the insertion of the $MIN_{CONF}$ architecture, the already implemented $MAX_{CONF}$ structure shall be preserved. The use of a test model (namely the ctldb), the use of the scan insertion options, and the steps flow previously described allow preservation of the inserted compressor architecture. The final circuit is shown in Fig. 6.

The test access mechanism (TAM) here described is based on a JTAG IEEE 1149.1 protocol.

Three control signals have been extracted, using dedicated or multiplexed external PADs, to control the functionality of the dual scan architecture.

A first signal 'select user-scan' is a global scan enable used to activate the scan mode and the shared PADs of $MIN_{CONF}$ in the dedicated multiplexer logic.

A second signal 'select min-max' selects one of the two modes, along with the scan chain outputs to be connected to the proper output PADs in the dedicated multiplexer logic.

A third and last signal, 'select bypass-comp' enables the proper DFT compressor architecture.

In case this third signal 'select bypass-comp' is not enabled, the standard scan chain is configured.

For the validation of the here proposed dual scan compression architecture in terms higher parallelism in the test phase and test data volume reduction

The $MIN_{CONF}$ compressor 3 architecture for EWS test allows using low cost test equipment because of a consistent reduction of data volume, which instead would be too large to be practically loaded if compressed architecture were not used. On the other side, a low parallelism is obtained using the $MAX_{CONF}$ compressor 4 architecture.

This dual mode compressed architecture allows a considerable reduction of both test time and test data volume, which although acceptable would be borderline in case the compressed architecture were not used.

Furthermore the area overhead contribution of $MIN_{CONF}$ (0.03%) is nearly negligible compared to the contribution of $MAX_{CONF}$ only (0.44%).

The multi-mode and dual scan compression architecture above described can be effectively used to overcome the mentioned technical problem, exploiting a double modes architecture that trades off between the opposite requests of high parallelism required by some test, for instance during the Electric Wafer Sort (EWS), and low parallelism required by some others tests, for instance the Final Test (FT).The improved scan compression architecture of the present invention relies is overcoming the current limitation of DFT Compiler tools to implement the improved architecture including, for each one of the two scan compression modes, the related DFT adaptive scan architecture hardware logic circuitry.

**Claims**

1. Scan compression architecture (1) for a Design For Testability compiler used in System-on-Chip software design tools, **characterized by** comprising at least a first and a second scan architecture on the same chip, said first scan architecture comprising a corresponding first scan compressor configuration ($MAX_{CONF}$) connecting all pins of said System-on-Chip, and a second scan architecture comprising a second scan compressor configuration ($MIN_{CONF}$) connecting a limited number of said pins, said first and second scan architectures being selectively enabled by an external control signal (*Low0_High1*) received on an input pin (10) of the chip, respectively, for reducing test time or increasing test parallelism.

2. Scan compression architecture according to claim 1 wherein each of said first and second compression configurations ($MIN_{CONF}$, $MAX_{CONF}$) may be enabled or bypassed thus providing two operating modes.

3. Scan compression architecture according to claim 1 wherein each of said first and second compression configurations ($MIN_{CONF}$, $MAX_{CONF}$) includes a respective number of scan chains (6, 8) incorporated into a single core logic (2) of the compression architecture (1) a linked to a respective numbers of input/output pins or pads (10, 7).

4. Scan compression architecture according to claim 3 wherein said control signal is used also to configure a Mux-Demux (5) for mapping the scan chains (6, 8) of said compression configurations ($MIN_{CONF}$, $MAX_{CONF}$).

5. Scan compression architecture according to claim 3 wherein an additional control signal (*CompEn*) is provided for selecting the behavior of the enabled compression configuration ($MIN_{CONF}$, $MAX_{CONF}$) that has been selected by said by control signal (*Low0_High1*).

6. Scan compression architecture according to claim 4 wherein in a first operating mode selecting one ($MIN_{CONF}$) of said compressors by said additional control signal (*CompEn*) allow the application of scan patterns in the Eletric Wafer Sort (EWS) testing phase with a limited number of scan chains, while the other operating mode selecting the other of said compressors ($MAX_{CONF}$) allows reducing the testing time and the test data volume in the Final Test (FT) phase in which all the PADs (10, 7) are connected to a test equipment

7. Scan compression architecture according to claim 4 wherein said control signal (*Low0_High1*) and said additional control signal (*CompEn*) are generated internally using a JTAG IEEE 1149.1 standard architecture.

8. Scan compression architecture according to claim 1 wherein said output PADs (10) can be shared between the two operation modes and selected by means of a dedicated output multiplexer logic, along with said external control signal.

9. Scan compression architecture according to claim 2 wherein each one of the two available operating modes can be suitably selected according to the specific testing case that has to be performed (e.g. EFTS or FT) .

10. Scan compression architecture according to claim 1 wherein one ($MIN_{CONF}$) of said scan compressor configuration ($MIN_{CONF}$, $MAX_{CONF}$) includes at least five scan chains while the other ($MAX_{CONF}$) includes twenty-three scan chains.

11. Method of designing a scan compression architecture through a Design For Testability (DFT) compiler used in System-on-Chip, **characterized by**:

- grouping together analogue and digital logic blocks in a single core logic block (2) connected to input/output pins (10, 7) of the System-on-Chip:

- inserting a group of reconfigurable scan chains (6, 8) into said core logic block (2);
- providing at least a first and a second scan hardware architecture in said core logic block (2) using, respectively, a first scan compressor configuration ($MAX_{CONF}$) connecting all pins of said System-On-Chip and a second scan compressor configurations ($MIN_{CONF}$) connecting a limited number of said pins, said first and second scan architectures being selectively enabled by a control signal received on an input pin (10) of the chip respectively, for reducing test time or increasing test parallelism.

**Patentansprüche**

1. Scan-Kompression-Architektur (1) für einen Entwurf-zur-Testbarkeit-Compiler, der in Software-Entwurfshilfsmitteln für ein auf einem Chip ausgeführtes System verwendet wird, **gekennzeichnet durch** Aufweisen mindestens einer ersten und einer zweiten Scan-Architektur auf dem selben Chip, wobei die erste Scan-Architektur eine zugehörige erste Scan-Kompressor-Konfiguration ($MAX_{CONF}$) aufweist, die alle Pins des auf dem Chip ausgeführten Systems verbindet, und wobei die zweite Scan-Architektur eine zweite Scan-Kompressor-Konfiguration ($MIN_{CONF}$) aufweist, die eine begrenzte Anzahl der Pins verbindet, wobei die erste bzw. die zweite Scan-Architektur selektiv **durch** ein an einem Eingangspin (10) des Chips empfangenes, externes Steuersignal (LowO_High1) aktiviert wird, um die Testzeit zu reduzieren oder die Testparallelität zu erhöhen.

2. Scan-Kompression-Architektur nach Anspruch 1, wobei jede der ersten und der zweiten Kompression-Konfiguration ($MIN_{CONF}$, $MAX_{CONF}$) aktiviert oder umgangen werden kann, wodurch zwei Betriebsmodi bereitgestellt werden.

3. Scan-Kompression-Architektur nach Anspruch 1, wobei jede der ersten und der zweiten Kompression-Konfiguration ($MIN_{CONF}$, $MAX_{CONF}$) eine jeweilige Anzahl von Scan-Ketten (6, 8) enthält, die in einer einzigen Kernlogik (2) der Kompression-Architektur (1) enthalten sind und mit einer jeweiligen Anzahl von Eingabe-/Ausgabe-Pins oder -Pads (10, 7) verbunden sind.

4. Scan-Kompression-Architektur nach Anspruch 3, wobei das Steuersignal auch dazu verwendet wird, einen Multiplexer-Demultiplexer (5) zu konfigurieren, um die Scan-Ketten (6, 8) der Kompression-Konfigurationen ($MIN_{CONF}$, $MAX_{CONF}$) zuzuordnen.

5. Scan-Kompression-Architektur nach Anspruch 3, wobei ein zusätzliches Steuersignal (CompEn) zum Auswählen des Verhaltens der aktivierten, durch das Steuersignal (LowO_High1) ausgewählten Kompression-Konfiguration ($MIN_{CONF}$, $MAX_{CONF}$) bereitgestellt ist.

6. Scan-Kompression-Architektur nach Anspruch 4, wobei, in einem ersten Betriebsmodus, das Auswählen von einem ($MIN_{CONF}$) der Kompressoren durch das zusätzliche Steuersignal (CompEn) das Anlegen von Scan-Mustern in der Elektrische-Wafer-Art ("Electric Wafer Sort", EWS)-Testphase mit einer begrenzten Anzahl von Scan-Ketten erlaubt, während, in dem anderen Betriebsmodus, das Auswählen des anderen der Kompressoren ($MAX_{CONF}$) ein Reduzieren der Testzeit und des Testdatenvolumens in der Endtest ("Final Test", FT)-Phase erlaubt, in der alle Pads (10, 7) mit einem Testgerät verbunden sind.

7. Scan-Kompression-Architektur nach Anspruch 4, wobei das Steuersignal (LowO_High1) und das zusätzliche Steuersignal (CorripEn) intern unter Verwendung einer JTAG IEEE 1149.1-Standardarchitektur erzeugt werden.

8. Scan-Kompression-Architektur nach Anspruch 1, wobei die Ausgabe-Pads (10) von den zwei Betriebsmodi gemeinsam benutzt werden können und zusammen mit dem externen Steuersignal mittels einer dedizierten Ausgabe-Multiplexer-Logik ausgewählt werden können.

9. Scan-Kompression-Architektur nach Anspruch 2, wobei jeder der zwei zur Verfügung stehenden Betriebsmodi auf geeignete Weise gemäß dem spezifischen Testfall, der ausgeführt werden muss (z.B. EWS oder FT), ausgewählt werden kann.

10. Scan-Kompression-Architektur nach Anspruch 1, wobei eine ($MIN_{CONF}$) der Scan-Kompressor-Konfigurationen ($MIN_{CONF}$, $MAX_{CONF}$) mindestens fünf Scan-Ketten enthält, während die andere ($MAX_{CONF}$) 23 Scan-Ketten enthält.

**11.** Verfahren des Entwerfens einer Scan-Kompression-Architektur durch einen Entwurf-zur-Testbarkeit (Design For Testability, DFT)-Compiler, der in einem auf einem Chip ausgeführten System verwendet wird, **gekennzeichnet durch**:

- Zusammenfassen von analogen und digitalen Logikblöcken in einem einzigen Kernlogikblock (2), der mit Eingabe-/Ausgabe-Pins (10, 7) des auf dem Chip ausgeführten Systems verbunden ist;
- Eingeben einer Gruppe von rekonfigurierbaren Scan-Ketten (6, 8) in den Kernlogikblock (2);
- Bereitstellen mindestens einer ersten Scan-Hardware-Architektur in dem Kernlogikblock (2), die eine erste, alle Pins des auf dem Chip ausgeführten Systems verbindende Scan-Kompressor-Konfiguration ($MAX_{CONF}$) verwendet, und einer zweiten Scan-Hardware-Architektur in dem Kernlogikblock (2), die eine zweite, eine begrenzte Anzahl der Pins verbindende Scan-Kompressor-Konfiguration ($MIN_{CONF}$) verwendet, wobei die erste bzw. die zweite Scan-Architektur selektiv durch ein an einem Eingabepin (10) des Chips empfangenes Steuersignal aktiviert wird, um die Testzeit zu reduzieren oder die Testparallelität zu erhöhen.

**Revendications**

**1.** Architecture de compression de balayage (1) pour un compilateur de conception en vue du test utilisée dans des outils de conception logicielle de système sur puce, **caractérisée en ce qu'**elle comprend au moins une première et une seconde architectures de balayage sur la même puce, la première architecture de balayage comprenant une première configuration de compresseur de balayage ($MAX_{CONF}$) correspondante permettant de connecter toutes les broches du système sur puce, et une seconde architecture de balayage comprenant une seconde configuration de compresseur de balayage ($MIN_{CONF}$) permettant de connecter un nombre limité de ces broches, les première et seconde architectures étant sélectivement activées par un signal de contrôle externe *(LowO_High1)* reçu sur une broche d'entrée (10) de la puce, respectivement, pour réduire la période de test ou augmenter le parallélisme de test.

**2.** Architecture de compression de balayage selon la revendication 1, dans laquelle chacune des première et seconde configurations de compression ($MIN_{CONF}$, $MAX_{CONF}$) peut être activée ou bypassée, fournissant ainsi deux modes de fonctionnement.

**3.** Architecture de compression de balayage selon la revendication 1, dans laquelle chacune des première et seconde configurations de compression ($MIN_{CONF}$, $MAX_{CONF}$) comprend un nombre respectif de chaînes de balayage (6, 8) incorporées dans une seule logique de coeur (2) de l'architecture de compression (1) reliées à un nombre respectif de broches ou de plages d'entrée/sortie (10, 7).

**4.** Architecture de compression de balayage selon la revendication 3, dans laquelle le signal de contrôle est également utilisé pour configurer un multiplexeur / démultiplexeur (5) pour le mappage des chaînes de balayage (6, 8) des configurations de compression ($MIN_{CONF}$, $MAX_{CONF}$).

**5.** Architecture de compression de balayage selon la revendication 3, dans laquelle un signal de contrôle supplémentaire (*CompEn*) est prévu pour sélectionner le comportement de la configuration de compression activée ($MIN_{CONF}$, $MAX_{CONF}$) qui a été sélectionnée par le signal de contrôle *(Low0_High1).*

**6.** Architecture de compression de balayage selon la revendication 4, dans laquelle dans un premier mode de fonctionnement, la sélection d'un ($MIN_{CONF}$) des compresseurs par le signal de contrôle supplémentaire *(CompEn)* permet l'application de modèles de balayage lors de la phase de test sous pointes (EWS) avec un nombre limité de chaînes de balayage, alors que dans l'autre mode de fonctionnement, la sélection de l'autre des compresseurs ($MAX_{CONF}$) permet de réduire la période de test et le volume de données de test lors de la phase de test final (FT) lors de laquelle toutes les plages (10, 7) sont connectées à un équipement de test.

**7.** Architecture de compression de balayage selon la revendication 4, dans laquelle le signal de contrôle *(Low0_High1)* et le signal de contrôle supplémentaire *(CompEn)* sont générés en interne au moyen d'une architecture standard JTAG IEEE 1149.1.

**8.** Architecture de compression de balayage selon la revendication 1, dans laquelle les plages de sortie (10) peuvent être partagées entre les deux modes de fonctionnement et sélectionnées au moyen d'un circuit de multiplexage de sortie dédié, avec le signal de contrôle externe.

9. Architecture de compression de balayage selon la revendication 2, dans laquelle chacun des deux modes de fonctionnement disponibles peut être sélectionné de manière adaptée en fonction du cas de test spécifique à effectuer (par exemple EWS ou FT).

10. Architecture de compression de balayage selon la revendication 1, dans laquelle une ($MIN_{CONF}$) des configurations de compresseur de balayage ($MIN_{CONF}$, $MAX_{CONF}$) comprend au moins cinq chaînes de balayage alors que l'autre ($MAX_{CONF}$) comprend vingt-trois chaînes de balayage.

11. Procédé de conception d'une architecture de compression de balayage par un compilateur de conception en vue du test (DFT) utilisé dans des systèmes sur puce, **caractérisé en ce qu'**il comprend des étapes consistant à :

- regrouper ensemble des blocs de logiques analogiques et numériques dans un seul bloc de logique de coeur (2) connecté à des broches d'entrée/sortie (10, 7) du système sur puce ;
- insérer un groupe de chaînes de balayage reconfigurables (6, 8) dans le bloc de logique de coeur (2) ;
- prévoir au moins une première et une seconde architectures hardware de balayage dans le bloc de logique de coeur (2) en utilisant, respectivement, une première configuration de compresseur de balayage ($MAX_{CONF}$) permettant de connecter toutes les broches du système sur puce et une seconde configuration de compresseur de balayage ($MIN_{CONF}$) permettant de connecter un nombre limité de ces broches, les première et seconde architectures de balayage étant sélectivement activées par un signal de contrôle reçu sur une broche d'entrée (10) de la puce, respectivement pour réduire la période de test ou augmenter le parallélisme de test..

Device

Scan Chain 0

Scan Chain 1

Scan Chain 2

Scan Chain X

Scan Chain N-2

Scan Chain N-1

Scan Chain N

Scan
Chain
Inputs

Scan
Chain
Outputs

Multi-Mode
Multiplexer

FIG. 1
PRIOR ART

EP 1 852 706 B1

FIG. 2
PRIOR ART

FIG. 3

EP 1 852 706 B1

FIG. 4

EP 1 852 706 B1

FIG. 5

EP 1 852 706 B1

FIG. 6

MAX_CONF Scan Inputs

MIN_CONF MAX_CONF Shared Scan Inputs

MAX_CONF Scan Outputs

MIN_CONF MAX_CONF Shared Scan Outputs

MAX_CONF Decompressor

Select Bypass-Comp

MAX_CONF Compressor

Dedicated Mux Logic

Max Input

Min Input

MIN_CONF Decompressor

Core Logic

MIN_CONF Compressor

Select Min-Max

Select User-Scan

EP 1 852 706 B1

PADs ring

Low0_High1

**4**

**5**

DeMux.

Max Comp.

Min Comp.

3

CompEn

Core Logic
MIN-MAX
scan chains
architecture

**2**

Max Decomp.

Min Decomp.

Mux

**1**

FIG. 7

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 1536244 A